Europäisches Patentamt

European Patent Office

Office européen des brevets

(11) Publication number: **0 090 586**
**B1**

(12) **EUROPEAN PATENT SPECIFICATION**

(45) Date of publication of patent specification: **03.06.87**

(51) Int. Cl.⁴: **C 23 C 16/50, H 01 J 37/32**

(21) Application number: **83301604.1**

(22) Date of filing: **22.03.83**

(54) Gas flow in plasma treatment processes.

(30) Priority: **31.03.82 JP 52992/82**

(43) Date of publication of application:
**05.10.83 Bulletin 83/40**

(45) Publication of the grant of the patent:
**03.06.87 Bulletin 87/23**

(84) Designated Contracting States:
**DE FR GB**

(56) References cited:
**GB-A-2 076 587**

**PATENTS ABSTRACTS OF JAPAN, vol. 6, no.
119(E-116)(997), 3rd July 1982 & JP - A - 57
48226 (Cat. D,A), (MATSUSHITA DENSHI
KOGYO K.K.) 19-03-1982**

**PATENTS ABSTRACTS OF JAPAN, vol. 3, no.
123(C-61), 16th October 1979, page 11C61 & JP
- A - 54 103 791 (TOKYO SHIBAURA DENKI K.K.)
15-08-1979**

(73) Proprietor: **FUJITSU LIMITED
1015, Kamikodanaka Nakahara-ku
Kawasaki-shi Kanagawa 211 (JP)**

(72) Inventor: **Fujimura, Shuzo
Tsudanuma Haimu B-307 3-13-1, Tsudanuma
Narashino-shi Chiba 275 (JP)**

(74) Representative: **Fane, Christopher Robin King
et al
HASELTINE LAKE & CO. Hazlitt House
28 Southampton Buildings Chancery Lane
London, WC2A 1AT (GB)**

(56) References cited:

**AIAA Journal Vol. 14 No. 5 (1976), pages
644-647;**

**J. Electrochem. Soc. Nov. 1982, pages 2537-
2541**

Courier Press, Leamington Spa, England.

## Description

This invention relates to gas flow in plasma treatment processes, more particularly where plasma generation and the treatment are effected in respective separate chambers.

Processes for the production of semiconductor devices include many steps in which gas treatment is carried out. In gas treatment steps for, in particular, dry etching, chemical vapor deposition (CVD), and the like, uniformity of treatment is an important factor. The uniformity of treatment in these gas treatment steps can be highly affected by conditions of the treating gas flow formed in the treating region.

For the selective etching of semiconductor layers, insulator films, interconnection layers, and the like, there has been employed, for example, a plasma etching apparatus of a construction having a plasma generating chamber and a treating chamber provided separately, such as schematically shown in Fig. 1 of the accompanying drawings (see, e.g., Japanese Examined Patent Publication (Kokoku No. 53-14472). In Fig. 1, 1 denotes a microwave generator, 2 a plasma generating chamber, 3 an etching gas feeding pipe, 4 a gas passageway, 5 a gas inlet, 6 a treating chamber, 7 an evacuation opening, 8 a material to be treated, 9 arrows indicating the direction of the gas flow, and P plasma.

In an apparatus having such a construction, an etching gas is converted into activated particles in the plasma generating chamber 2, which are blown into the treating chamber 6 directly from the gas inlet 5, are reacted with the material 8, and are then discharged. The etch rate of the material to be treated depends on the accession percentage of the activated particles to the surface of the material to be treated and on the proportion of the elimination of the reaction product. Thus, the etch rate is highly affected by the positions of the gas inlet 5, evacuation openings 7, and the like. Thus, when a polycrystalline silicon layer of a thickness of about 0.4 μm (4,000 Å) formed on a substrate of a diameter of 125 mm (5 in.) is etched on an apparatus of the above-mentioned construction, using a carbon tetrafluoride ($CF_4$)/oxygen ($O_2$) mixture having a usual composition as the etching gas, at a gas pressure of about 40 Pa (0.3 torr.), a 10% to 20% variation of the etch rate occurs in the surface area and the width of the formed pattern varies by 0.15 μm or more.

The above-mentioned variation of etch rate may be improved by further reducing the gas pressure in the treating chamber. However, in this case, the reduction of the gas pressure for the purpose of extremely lowering the etch rate may result in the problem of a notable reduction in the amount of the activated particles.

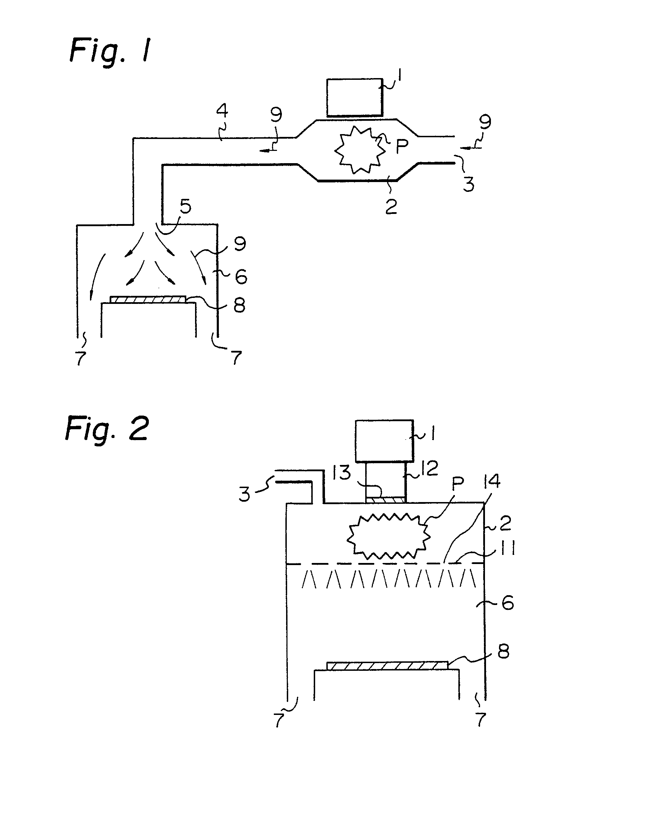

There has also been employed an apparatus of a construction, as shown in Fig. 2, wherein a plasma generating chamber 2 and a treating chamber 6 are separated by a plasma regulating panel 11 having punched holes. In this apparatus, an etching gas introduced from an etching gas feeding pipe into the plasma generating chamber 2 is converted into activated particles by irradiating the etching gas with microwaves from a microwave generator 1 through a waveguide 12 and a microwave transmitting window 13, thereby generating plasma P. The activated particles are then introduced into the treating chamber 6 which has been evacuated through evacuation openings 7, by the pressure difference, from a plurality of gas introducing holes 14 formed in the plasma regulating panel 11 and act to etch a material 8 to be treated. Reference numeral 3 denotes an etching gas feeding pipe.

In an apparatus having such a construction, however, uniformity of etch rate proves elusive even if the gas introducing holes are changed in number, size, or shape. The arrangement of the holes in the panel 11 and the direction of the gas flow being discharged may also cause variation in the etch rate, particularly when a few holes having a small diameter are provided. For example, when a polycrystalline silicon layer of a thickness of about 0.4 μm (4,000 Å) formed on a substrate of a diameter of 125 mm (5 in.) is etched using a mixed carbon tetrafluoride ($CF_4$)/oxygen/ $O_2$ gas as the etching gas at a gas pressure of $1.3 \times 10^2$ to $2.6 \times 10^2$ Pa) (1.0 to 2.0 torr.), the width of the formed pattern inevitably varies more than 0.3 μm. Furthermore, it is difficult for the construction of the plasma regulating panel to be changed as desired so as to obtain high uniformity of the etching, even when the etching conditions such as the composition of the etching gas and the gas discharging rate are varied.

It is desirable to provide a process and apparatus for plasma treatment in which a small variation of treatment rate can be achieved by simple means.

An embodiment of the present invention provides a process for plasma treatment using a plasma generating chamber and a separate treating chamber, which comprises introducing an activated gas excited in the plasma generating chamber into the treating chamber through an inlet opening, so that the activated gas impinges upon a baffle, positioned in front of said inlet opening, distributing the activated gas within the treating chamber by means of the baffle after the activated gas has impinged thereupon and bringing the activated gas into contact with the surface of a material to be treated downstream of the baffle within the treating chamber.

Another embodiment of the present invention provides an apparatus for carrying out a plasma treatment process, which apparatus includes a plasma generation chamber in which a working gas is activated when the apparatus is in use and a treatment chamber for containing an item to be treated in the said process, the treatment chamber having an inlet opening through which activated working gas passes into that chamber from the plasma generation chamber when the apparatus is in use, characterized in that a baffle is supported in the said treatment chamber in confronting relationship with the said inlet opening so as to be interposed between said inlet opening and said item and so that the activated gas impinges upon the baffle and thereafter is distributed within the treatment chamber, when the apparatus is in use.

The introduction of the activated gas into the treating chamber may preferably be controlled by means of a conductance regulating means provided at the said inlet opening.

Figures 1 and 2 are cross-sectional views of conventional plasma etching apparatus;

Fig. 3A is a cross-sectional view of a gas distribution controlling means consisting of a conductance regulating means and a baffle for use in an embodiment of the present invention;

Fig. 3B is a plan view of the gas distribution controlling means shown in Fig. 3A; and

Figs. 4 and 5 are cross-sectional views of an embodiment of the plasma treating apparatus according to the present invention.

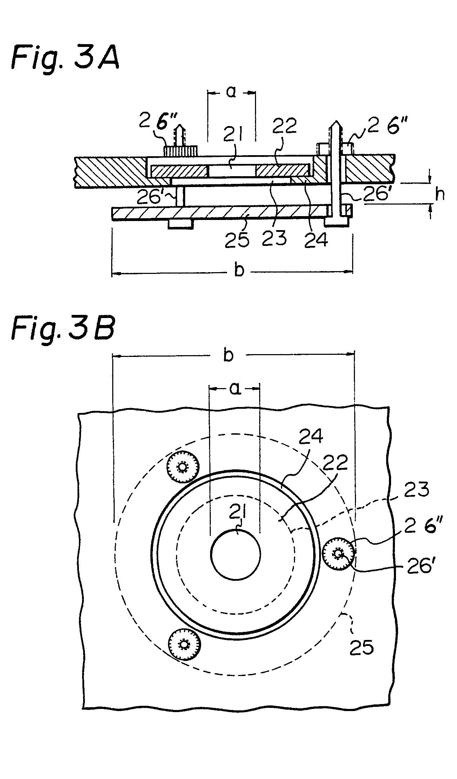

In an embodiment of the invention, the baffle is preferably employed in combination with a gas conductance regulating means forming a gas distribution controlling means, as shown in Figs. 3A and 3B.

Referring to Figs. 3A and 3B, the gas conductance regulating means is comprised of a conductance regulating plate 22 in the form of a disc, having a circular opening 21 and a supporting mechanism 24 for supporting the conductance regulating plate 22, provided at the periphery of a circular opening 23 for introducing the activated gas into the treating chamber. The introduction of the gas can be regulated, for example, by changing regulating plates 22 with openings 21 of different diameters a. Alternatively, the diameter of the opening 21 may be changed by means of a shutter mechanism. The main purpose of the conductance regulating plate 22 is to keep the rate of introduction of the activated gas into the treating chamber within a proper range in conformity with the change of the composition of the gas, the shape of the gas passageway, and other treatment conditions. Thus, the conductance regulating plate need not be provided if no change of the treatment conditions is required.

To promote a desirably diffuse flow of activated working gas in treatment chamber 30, a baffle is provided in the form of, for example, a circular plate 25 having a diameter b, fixed in front of the inlet opening 23 by means of three pairs of bolts 26' and nuts 26'' with a proper distance h from the open surface of the inlet opening 23. The diffusion of the activated gas may effectively be controlled by changing baffle plates 25 with different diameters and by changing the distance h between the baffle plate 25 and the open surface of the inlet opening 23 or the angle of the baffle plate 25 to the axis of the inlet opening 23 by means of the combinations of the bolts 26' and the nuts 26''. The baffle plate 25 is located at a position opposed to the inlet opening 23 in the treating chamber and acts to diffuse the activated gas which has once struck against this plate 25. The optimum size, shape and position of the plate 25 may largely depend on the shape of the inside of the treating chamber.

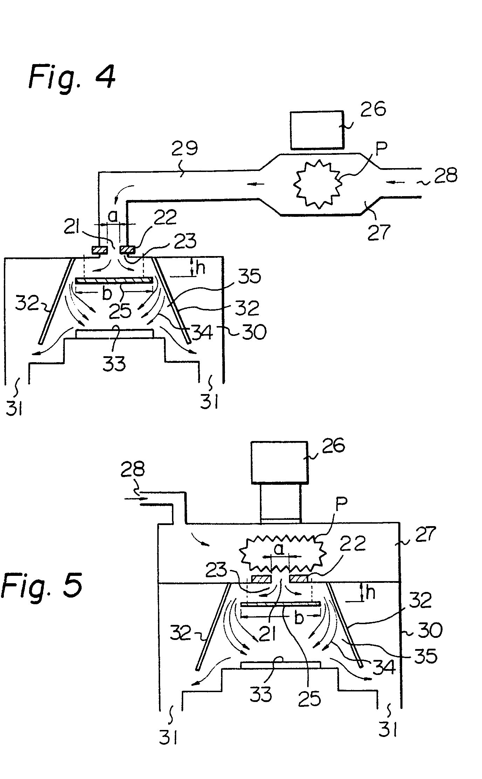

In Figs. 4 and 5 are schematically shown embodiments of plasma treatment apparatus according to the present invention, provided with the above-mentioned gas distribution controlling means. In these figures, 21 denotes an opening of a conductance regulating plate, 22 the conductance regulating plate, 23 an inlet opening for an activated gas provided in the upper portion of a treating chamber, 25 a baffle plate, 26 a microwave generator, 27 a plasma generating chamber, 28 a treating gas feeding pipe, 29 a gas passageway, 30 the treating chamber, 31 an evacuation opening, 32 a barrier, 33 a material to be treated, 34 an arrow indicating the direction of the gas flow, P plasma, a the diameter of the opening 21 of the conductance regulating plate 22, b the diameter of the plate 25, and h the distance between the plate 25 and the inlet opening 23.

In these apparatuses, a frusto-conical barrier 32 is provided so as to cover the material 33 to be treated and to define a limited treating region 35. The restriction of the treating region 35 to a limited space is advantageous in the case where the treating chamber 30 has a large plane area. Thus, in the case where the plane area of the treating chamber 30 is about 4 to 5 times, or less, the area of the treating surface, it may not be necessary to provide such a barrier.

The above-mentioned conductance regulating plate, baffle plate, and barrier may advantageously be made of a material, e.g., aluminum, highly resistant to a treating gas such as an etching gas.

The present invention will further be illustrated below with reference to an etching example which was carried out using one of the apparatuses mentioned above.

In the apparatus employed, the upper diameter of the limiting barrier 32 was 130 mm, the lower diameter thereof was 160 mm, and the height thereof, i.e., the distance between the ceiling of the treating chamber 30 and the lower periphery of the barrier 32, was 80 mm. The distance between the ceiling of the treating chamber 30 and the surface of the material 33 to be treated was 70 mm. The diameter a of the opening 21 of the conductance regulating plate 22 was adjusted to 12.5 mm so that the inner pressure of the plasma generating chamber was well maintained and the activated species existed in a satisfactory amount. A mixed gas consisting of $CF_4$ and $O_2$ was fed as the etching gas at a rate of 400 $cm^3$/min of $CF_4$ and 120 $cm^3$/min of $O_2$ and then activated by irradiating it with microwaves of 2.45 GHz and 1 kW to form activated species. The gas pressure in the treating chamber was adjusted to 67 to 134 Pa (0.5 to 1 torr.). The baffle plate 25 was maintained parallel to the open surface of the inlet opening 23.

A polycrystalline silicon layer formed on a material (substrate) 33 of a diameter of 125 mm (5 in.) was etched under the above conditions with different diameters b of the baffle plate 25 and distances h between the baffle plate 25 and the open surface of the inlet opening 23. The variation of the etch rate in the etched surfaces was then evaluated.

The results are shown in Table 1 and Table 2 below. Table 1 shows the results obtained by fixing the diameter b to 90 mm and varying the distance h, while Table 2 shows the results obtained by fixing the distance h to 1.5 mm and varying the diameter b.

TABLE 1

| h in mm | Etch rate variation in % |
|---------|--------------------------|
| 1.5 | 4 |
| 5 | 7—8 |
| 10 | >10 |

TABLE 2

| b in mm | Etch rate variation in % |
|---------|--------------------------|
| 60 | 4 to 5 |
| 90 | 4 |
| 100 | 3.5 to 4 |

From the results, it is apparent that, in the above-mentioned etching, it is desirable that the diameter b of the baffle plate 25 be adjusted to 100 mm and the distance h between the baffle plate 25 and the open surface of the inlet opening 23 be adjusted to 1.5 mm. In this case, a variation of etch rate of only about 4% can be obtained, a notable improvement compared with the 10% to 20% of the conventional etching process as mentioned hereinbefore. It is further apparent that the variation of etch rate was improved in all cases by the use of the baffle plate.

In the above-mentioned etching example, the gas pressure in the treating chamber was 13 to 134 Pa (0.1 to 1 torr), which is about 2 to 3 times the gas pressure in conventional etching processes. Thus, the etch rate was about 350 to 400 nm/min (3,500 to 4,000 Å/min), which is about 2 times the etch rate in conventional etching processes.

In the apparatus employed in the above example, the plasma etching region was defined by the barrier. However, similar results may be obtained without the use of a barrier if an apparatus having a treating chamber of an inner diameter of 160 to 180 mm is employed.

Further, if the angle of the baffle plate to the axis of the activated gas opening is changed so that the baffle plate is located not parallel to the open surface of the activated gas opening, it is possible to intentionally vary the etch rate in the treated surface.

In embodiments of the present invention, as explained above, a variation of etch rate of only about 4% can be obtained in the etching of a substrate having a diameter of about 125 mm (5 in). Therefore, a variation of not more than 0.1 μm can be attained in the width of the formed pattern and, thus, semiconductor devices having fine patterns, such as large scale integration devices, can effectively be produced.

Further, the present invention can be used for the etching of materials other than the polycrystalline silicon layer and is also useful for plasma CVD.

**Claims**

1. Apparatus for carrying out a plasma treatment process, which apparatus includes a plasma generation chamber (27) in which a working gas is activated when the apparatus is in use and a treatment chamber (30) for containing an item (33) to be treated in the said process, the treatment chamber having an inlet opening (23) through which activated working gas passes into that chamber from the plasma generation chamber when the apparatus is in use, characterized in that a baffle (25) is supported in the said treatment chamber in confronting relationship with the said inlet opening (23) so as to be interposed between said inlet opening and said item (33) and so that the activated gas impinges upon the baffle and thereafter is distributed within the treatment chamber, when the apparatus is in use.

2. Apparatus as claimed in claim 1, wherein the gas-flow path between the plasma generation chamber and the treatment chamber is provided with flow-control means (22) whereby the conductance of that path can be selectively changed.

3. Apparatus as claimed in claim 2, wherein such change of the said conductance is effected by changing the area of an opening (21) through which the gas flows along said path.

4. Apparatus as claimed in claim 2 or 3, wherein the said flow-control means (22) are provided at the said inlet opening (23).

5. Apparatus as claimed in any preceding claim, including means whereby the effective baffle-area of the said baffle (25) can be changed.

6. Apparatus as claimed in any preceding claim, wherein the baffle (25) is adjustably mounted to permit selective variation of the distance between the inlet opening and the baffle.

7. Apparatus as claimed in any preceding claim, wherein the baffle (25) is adjustably mounted to permit selective variation of the angle between the axis of gas flow through the said inlet opening and a main plane of the baffle.

8. Apparatus as claimed in any preceding claim, wherein a gas-confining barrier (32) is provided within the treatment chamber, in surrounding relationship to the said baffle, to confine the activated gas laterally to a restricted region of the treatment chamber as the gas passes from the inlet opening to said item (33) when the apparatus is in use.

9. A process for plasma treatment using a plasma generating chamber (27) and a separate treating chamber (30) which comprises:

introducing an activated gas excited in the plasma generating chamber (27) into the treating chamber through an inlet opening (23), so that the activated gas impinges upon a baffle (25) positioned in front of said inlet opening;

distributing the activated gas within the treating chamber by means of the baffle after the activated gas has impinged thereupon; and

bringing the activated gas into contact with the surface of a material to be treated downstream of the baffle within the treating chamber.

10. A process as claimed in claim 9, using apparatus as claimed in any one of claims 2 to 8.

**Patentansprüche**

1. Vorrichtung zur Durchführung eines Plasmabehandlungsverfahrens, welche Vorrichtung eine Plasmaerzeugungskammer (27) umfaßt, in der ein Arbeitsgas aktiviert wird, wenn die Vorrichtung in Betrieb ist, und eine Behandlungskammer (30), zum Einschließen eines Gegenstands (33), der bei dem genannten Verfahren behandelt werden soll, wobei die Behandlungskammer eine Einlaßöffnung (23) hat, durch die aktiviertes Arbeitsgas von der Plasmaerzeugungskammer in die Kammer eintritt, wenn die Vorrichtung benutzt wird, dadurch gekennzeichnet, daß eine Trennwand (25) in der genannten Behandlungskammer gegenüber der genannten Einlaßöffnung (23) so unterstützt ist, daß sie zwischen der genannten Einlaßöffnung und dem Gegenstand (33) angeordnet ist, und so, daß das aktivierte Gas auf die Trennwand aufstößt und danach innerhalb der Behandlungskammer verteilt wird, wenn die Vorrichtung in Benutzung ist.

2. Vorrichtung nach Anspruch 1, bei der der Gasströmungsweg zwischen der Plasmaerzeugungskammer und der Behandlungskammer mit einer Strömungssteuereinrichtung (22) versehen ist, durch welche die Konduktanz des Weges wahlweise geändert werden kann.

3. Vorrichtung nach Anspruch 2, bei der solch eine Änderung der genannten Konduktanz durch Änderung der Fläche eine Öffnung (21) bewirkt wird, durch welche das Gas längs dem genannten Weg strömt.

4. Vorrichtung nach Anspruch 2 oder 3, bei der die genannte Strömungssteuereinrichtung (22) an der Einlaßöffnung (23) vorgesehen ist.

5. Vorrichtung nach einem der vorhergehenden Ansprüche, mit einer Einrichtung, durch die der effektive Trennbereich der genannten Trennwand (25) geändert werden kann.

6. Vorrichtung nach einem der vorhergehenden Ansprüche, bei der die Trennwand (25) einstellbar montiert ist, um die wahlweise Variation des Abstandes zwischen der Einlaßöffnung und der Trennwand zuzulassen.

7. Vorrichtung nach einem der vorhergehenden Ansprüche, bei der die Trennwand (25) einstellbar so montiert ist, daß die selektive Veränderung des Winkels zwischen der Achse des Gasstromes durch die genannte Einlaßöffnung und einer Hauptebene der Trennwand ermöglicht ist.

8. Vorrichtung nach einem der vorhergehenden Ansprüche, bei der die Gasbegrenzungsbarriere (32) innerhalb der Behandlungskammer, in umgebender Relation zu der genannten Trennwand, vorgesehen ist, um das aktivierte Gas seitlich in einem beschränkten Bereich der Behandlungskammer zu begrenzen, während das Gas von der Einlaßöffnung zu dem Gegenstand (33) strömt, wenn die Vorrichtung in Benutzung ist.

9. Verfahren zur Plasmabehandlung unter Verwendung einer Plasmaerzeugungskammer (27) und einer separaten Behandlungskammer (30), welches umfaßt:

Einführung eines aktivierten Gases, das in der Plasmaerzeugungskammer (27) angeregt wird, in die Behandlungskammer, durch eine Einlaßöffnung (23), so daß das aktivierte Gas auf eine Trennwand (25) aufstößt, die gegenüber der genannten Einlaßöffnung positioniert ist;

Verteilung des aktivierten Gases innerhalb der Behandlungskammer mittels der Trennwand, nachdem das aktivierte Gas auf dieses aufgestoßen ist; und

Verbringen des aktivierten Gases in Berührung mit der Oberfläche des zu behandelnden Materials, stromabwärts von der Trennwand innerhalb der Behandlungskammer.

10. Vorrichtung nach Anspruch 9, unter Verwendung einer Vorrichtung nach einem der Ansprüche 2 bis 8.

**Revendications**

1. Appareil pour la mise en oeuvre d'un procédé de traitement au plasma, cet appareil comportant une chambre (27) de production de plasma dans laquelle un gaz de travail est activé quand l'appareil est en utilisation et une chambre de traitement (30) destinée à contenir un article (33) à traiter selon ledit procédé, la chambre de traitement comprenant une ouverture d'entrée (23) par laquelle le gaz de travail activé pénêtre dans la chambre depuis la chambre de production de plasma quand l'appareil est en utilisation, caractérisé en ce qu'un déflecteur (25) est supporté dans ladite chambre de traitement en regard de ladite ouverture d'entrée (23) de manière à être intercalé entre ladite ouverture d'entrée et ledit article (33) et de manière que le gaz activé recontre le déflecteur et soit ensuite distribué dans ladite chambre de traitement quand l'appareil est en utilisation.

2. Appareil selon la revendication 1, dans lequel le trajet de circulation du gaz entre la chambre de production de plasma et la chambre de traitement est muni d'un dispositif de contrôle de circulation (22) de manière que la conductance de ce trajet puisse être changée sélectivement.

3. Appareil selon la revendication 2, dans lequel ce changement de ladite conductance est effectué en changeant la surface d'une ouverture (21) par laquelle le gaz circule le long dudit trajet.

4. Appareil selon la revendication 2 ou 3, dans lequel ledit dispositif de contrôle de circulation (22) est prévu à ladite ouverture d'entrée (23).

5. Appareil selon l'une quelconque des revendications précédentes comportant un dispositif par lequel la surface effective du déflecteur (25) peut être changée.

6. Appareil selon l'une quelconque des revendications précédentes, dans lequel le déflecteur (25) est monté de façon réglable pour permettre une variation sélective de la distance entre l'ouverture d'entrée et le déflecteur.

7. Appareil selon l'une quelconque des revendications précédentes, dans lequel le déflecteur (25) est monté de façon réglable pour permettre une variation sélective de l'angle entre l'axe de circulation du gaz par ladite ouverture d'entrée et un plan principal du déflecteur.

8. Appareil selon l'une quelconque des revendications précédentes, dans lequel une barrière de confinement de gaz (32) est prévue dans la chambre de traitement entourant ledit déflecteur pour confiner latéralement le gaz activé à une région restreinte de la chambre de traitement quand le gaz passe depuis l'ouverture d'entrée vers ledit article (33) quand l'appareil est en utilisation.

9. Procédé de traitement au plasma utilisant une chambre de production de plasma (27) et une chambre de traitement (30) séparées, consistant: à introduire un gaz activé, excité dans la chambre de production de plasma (27), dans la chambre de traitement par une ouverture d'entrée (23) de manière que le gaz activé recontre un déflecteur (25) positionné devant ladite ouverture d'entrée; à distribuer le gaz activé dans la chambre de traitement au moyen du déflecteur après que le gaz activé l'a recontré; et à amener le gaz active en contact avec la surface d'une matière à traiter au-dessous du déflecteur dans ladite chambre de traitement.

10. Procédé selon la revendication 9, utilisant un appareil tel que revendiqué dans l'une quelconque des revendications 2 à 8.

0 090 586

*Fig. 1*

*Fig. 2*

*Fig. 3A*

*Fig. 3B*

# Fig. 4

# Fig. 5